**Europäisches Patentamt**

(19) **European Patent Office**

**Office européen des brevets**

(11) Publication number: **0 068 091**
**B1**

(12) **EUROPEAN PATENT SPECIFICATION**

(45) Date of publication of patent specification: **10.08.88**

(21) Application number: **82103179.6**

(22) Date of filing: **15.04.82**

(51) Int. Cl.⁴: **H 01 L 23/48,** H 01 L 21/60

(54) Method for connecting a semiconductor chip to a substrate and such connection.

(30) Priority: **30.06.81 US 278930**

(43) Date of publication of application:
**05.01.83 Bulletin 83/01**

(45) Publication of the grant of the patent:
**10.08.88 Bulletin 88/32**

(84) Designated Contracting States:
**DE FR GB**

(56) References cited:
**EP-A-0 009 131**
**EP-A-0 061 593**
**US-A-4 113 578**

**THE ELECTRONIC ENGINEER, vol. 28, no. 6, June 1969, pages 10,13, Radnor, USA; "IBM goes from copper balls to solder pads"**
**21ST ELECTRONIC COMPONENTS CONFERENCE, 10th-12th May 1971, pages 275-284, Washington D.C., USA; P.A. TOTTA: "Flip chip solder terminals"**

(73) Proprietor: **International Business Machines Corporation**
**Old Orchard Road**
**Armonk, N.Y. 10504 (US)**

(72) Inventor: **Bhattacharya, Somnath**
**13 Queen Anne Lane**
**Wappingers Falls, NY 12590 (US)**
Inventor: **Koopman, Nicholas George**
**Frances Drive**
**Hopewell Junction, NY 12533 (US)**
Inventor: **Totta, Paul Anthony**
**29 Sandi Drive**
**Poughkeepsie, NY 12603 (US)**

(74) Representative: **Barth, Carl Otto et al**
**IBM Deutschland GmbH Patentabteilung**
**Schönaicher Strasse 220**
**D-7030 Böblingen (DE)**

EP 0 068 091 B1

# Description

This invention relates to a means for forming interconnections between an insulator substrate and a thin film device or chip in particular to an improved means for interconnecting.

In US—A—4113578, there is described a thin film terminal pad suitable for a solder mound electrically and mechanically connecting a semiconductor integrated circuit chip to conductors on a substrate, the terminal pad comprising sequential layers of chromium (17), copper (18) and gold (20, 21) (see column 9, lines 5—40). It is stated in line 20, column 9 that the copper layer can have a thickness of up to 5000 Å.

Applicants have recognized that the stresses, initially within acceptable bounds, can change markedly after depositing the solder or braze alloy, by formation of intermetallic compounds at the interface between the solder and terminal metals. The intermetallic compound formed by conversion of the thin film metals has an entirely different structure, volume and expansion coefficient than the component metals from which it was produced. One example is the assembly of a chip device to a substrate employing a lead-tin solder pad, and chromium-copper-gold terminal metallurgy on sputtered silicon dioxide insulator. As evaporated, such a structure is stable, but after reflow and joining of the device to the substrate, structural changes occur which make the underlying silicon dioxide prestressed to such an extent that it is very susceptible to cracking.

It is further recognized that the structure of the final terminal depends not only upon the starting terminal structure at the device, but also the substrate. For example, elements such as Au, from the substrate terminal, can upon reflow and solidification, dissolve, migrate to the chip terminal, and epitaxially solidify out as AuSn or AuCuSn intermetallics. Therefore, the final amount and distribution and stress level need to be specified for the resultant joint to be stable. The simplest and most effective way to achieve this end is to restrict the total amount of copper and gold in the starting terminals plus solder, so that upon reaction and moving around, even if they were all concentrated in one terminal, there would not be enough intermetallic to cause a stress problem.

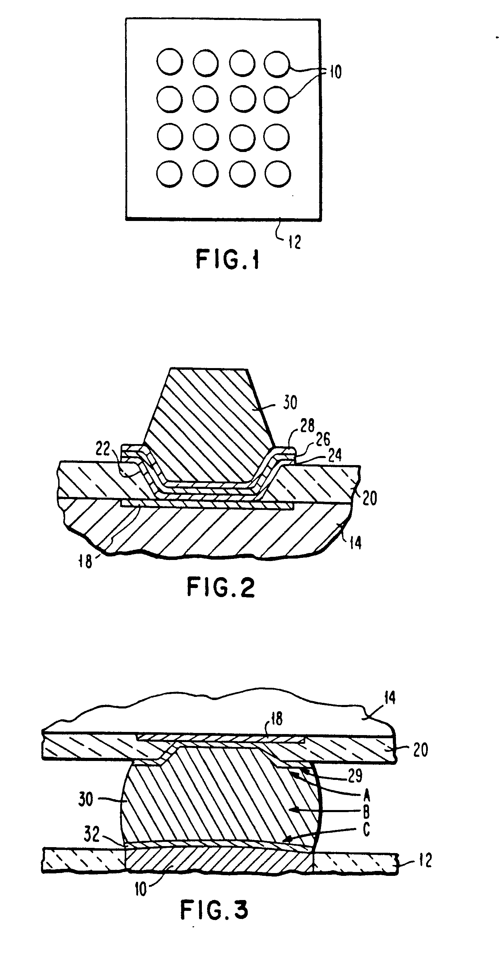

Once recognized that it is the final intermetallic distribution which is important, one can envision other approaches to the problem. For example, one could try to restrict the amount of intermetallic which forms by using a very short cycle time for reflow and joining. This is deemed impractical in light of the extreme thermal shock which would occur should such a rapid cycle be accomplished. One could break up the intermetallic by multiple reflow induced spalling or solution assisted spalling by addition of other elements to the joint, such as Pd. One could impose a temperature gradient while the pad is molten to drive the stress forming elements to the cold side of the joint [multi-layer ceramic (MLC) side] where the stress may not be a problem (see Fig. 3).

U.S. Patents 3 436 818 and 3 508 118 describe a circuit structure and method of fabricating a bonded joint that are similar to the structure and method described in this application, except that applicants are disclosing a modification in structure and an improvement in structural stability not taught in the patents.

Any metal in a joint that reacts with another metal in a substantially liquid state in soldering or brazing operations and forms a hard and brittle surface that epitaxially deposits and remains contiguous with a substrate may prestress a joint and the insulator to such extent that cracking may ensue. To avoid such cracking, applicants have recognized the requirement for restriction of the amounts of such materials in the joint.

In principle, the invention consists in limiting the thickness of at least the Cu layer when depositing sequential layers of Cr, Cu, and Au on a conductor pattern for bonding chips to a substrate.

An embodiment of the invention will be described in detail with reference to the drawing in which:

FIG. 1 is a plan view of a microelectronic dielectric substrate with a conductive pattern formed thereon;

FIG. 2 is a sectional view, partially broken away, of a chip with a solder contact prior to reflow; and

FIG. 3 is a sectional view illustrating a completed connection of a chip and a substrate, in accordance with the invention.

With reference to the drawing, a pattern of conductors 10 is formed on a surface of a substrate 12, such as multi-layer ceramic (MLC). The conductor pattern includes connection points for receiving semiconductor circuit chips 14, and the conductors 10, which may be made of molybdenum for example, are connected to terminals 32 of NiAu in a well-known manner.

During fabrication of each chip 14, an aluminum land 18 is deposited on each semiconductor region of the chip to provide an ohmic contact. A layer 20 of $SiO_2$ is then deposited over the surface of the chip 14 to provide environmental protection. Via apertures 22 are etched in the $SiO_2$ layer 20 directly over the aluminum land 18 to expose the land for subsequent metallization steps.

In this embodiment, the metallization steps include vacuum deposition of successive thin film layers of chromium 24, copper 26 and gold 28 to provide electrical contact to the aluminum land 18. The chromium film which is between 0.12 μm and 0.18 μm (1200 Å—1800 Å) thick serves as an adhesive and provides a glass to metal seal and protects the contact area from the environment. The copper and gold layers enable the adherence of metals to the chromium sealing film 24.

Thereafter, solder mounds 30 formed from lead and tin of approximately 125μm total thickness are vacuum deposited through a mask to contact the gold layer 28. The solder mounds 30 serve to space the chip 14 from the substrate 12 while providing good mechanical and electrical interconnection between the chip 14 and the conductive pattern 10.

After vacuum deposition of the solder mounds 30, the entire assembly is fired so that the solder mounds reflow. As a result, the relatively low stressed layers of copper 26 and gold 28 are converted into highly stressed layers of intermetallics 29 formed of Au and Cu with Sn, such as $Cu_3Sn$, AuCuSn, AuSn. The substrate 12 is then cleaned and the conductor pattern 10 is subjected to a fluxing process so that the chip devices 14 may be suitably joined to the substrate. The chip devices are fused to the substrate by a reflow operation, followed by cooling of the substrate at the end of the heating cycle to solidify the solder.

In an implementation of this invention, the copper layer 26, which is formed with the metallized terminal that also includes chromium 24 and gold 28, is deposited to a thickness of 0.08—0.25 µm (800—2500 Å). Applicants have discovered that by restricting the amount of elements such as Au, Cn and Sn in the joint that can epitaxially deposit intermetallic and remain contiguous on the surface of the converted solderable film, i.e., by making the copper and gold layers thin within the specified critical range, the intermetallic stress that occurs with the conversion of the copper and gold layers as a result of solder reflow and joining of a chip device to the substrate is substantially reduced or eliminated. By virtue of depositing the copper layer to a thickness of 0.08—0.25 µm (800—2500Å) there is a major reduction in susceptibility to cracking of the quartz insulator. Furthermore, to enhance the interconnection, the gold layer 28 in combination with any Au in the substrate is formed to a total thickness of no more than 0.25 µm (2500 Å).

By virtue of restricting the amount of copper and gold in the solder joint to the specified layer thicknesses, a substantial reduction in the incidence of cracking of the substrates employed for supporting circuit chip devices has been realized.

An alternative approach for preventing the cracking of the substrate during solder bonding of a semi-conductor chip to a substrate is to spall off the intermetallic material, and to disperse the material into the solder by extended reflow. However, this approach is not as effective as controlling the amount of copper and gold in the interconnection between a chip device and a substrate.

With reference to FIG. 3, it should be noted that the critical location of intermetallics for stressing of $SiO_2$ appears at area A. If the intermetallics were at areas B or C, the stressing problem would not develop.

## Claims

1. An electrical and mechanical connection between a semiconductor chip (14) and conductors (10) on an insulating substrate (12), said connection comprising a solder mound (30) and a terminal pad affixing said solder mound to said chip and/or said substrate, wherein before the formation of said connection, said terminal pad includes sequential layers of chromium (24), copper (26) and gold (28), said copper layer being 0.08 to 0.25 µm (800—2500Å) thick, so that on forming the said connection by reflow of the mound the sequential layers are converted into a layer of intermetallics and the stresses that occur with the formation of the intermetallics are reduced.

2. The connection of claim 1 or 2, wherein said gold layer (28) is no more than 0.25 µm (2500 Å) thick.

3. The connection of claim 1 or 2, wherein said terminal pad is affixed to said chip (14), further including an aluminum land (18) disposed on said chip.

4. A method for electrically and mechanically connecting an integrated circuit chip (14) to conductors (10) on an isolating substrate (12), characterized by the following steps

a) sequentially depositing layers of chromium (24), copper (26), and gold (28), said copper layer being 0.08 to 0.25 µm (800—2500 Å) and said gold layer preferably being no more than 0.25 µm (2500 Å) thick;

b) forming a lead/tin solder mound (30) on said deposited layers (24—28), said mound preferably having about 125 µm total thickness;

c) reflowing the solder mound, converting said deposited layers into a layer of intermetallics (29); and

d) mounting said chip (14) to said substrate (12).

5. The method of claim 4, wherein said reflowing and said mounting steps are combined.

## Patentansprüche

1. Elektrische und mechanische Verbindung zwischen einem Halbleiterchip (14) und Leitern (10) auf einem Isoliersubstrat (12) folgendes enthaltend: einen Lötkegel (30) und eine Anschlußstelle, welche den Lötkegel auf einem Chip und/oder dem Substrat befestigt, wobei vor der Herstellung der Verbindung die Anschlußstelle aufeinanderfolgende Schichten aus Chrom (24), Kupfer (26) und Gold (28) aufweist, und wobei die Kupferschicht 0,08 bis 0.25 µm (800 bis 2500 Å) dick ist, so daß beim Herstellen der Verbindung durch das Rückfließen des Lots die aufeinanderfolgenden Schichten in eine Schicht aus intermetallischen Verbindungen umgewandelt und die bei der Bildung der intermetallischen Verbindungen auftretenden Belastungen reduziert werden.

2. Verbindung nach Anspruch 1 oder 2, worin die Goldschicht (28) nicht mehr als 0,25 µm (2500 Å) dick ist.

3. Verbindung nach Anspruch 1 oder 2, worin die Anschlußstelle an dem Chip (14) befestigt wird, welches außerdem eine Aluminiumzone (18) aufweist.

4. Verfahren zum elektrischen und mechanischen Verbinden eines Chips (14) mit integrierter Schaltung mit Leitern (10) auf einem Isoliersubstrat (12), gekennzeichnet durch folgende Schritte:

a) sequentielles Aufbringen von Schichten aus Chrom (24), Kupfer (26), und Gold (28), wobei die Kupferschicht 0,08 bis 0,25 µm (800—2500 Å) und die Goldschicht bevorzugt nicht mehr als 0,25 µm (2500 Å) dick ist;

b) Ausbilden eines Blei/Zinn-Lötkegels (30) auf den aufgetragenen Schichten (24—28), dessen Gesamtdicke bevorzugt ungefähr 125 µm beträgt;

c) Aufschmelzen des Lots zum Umwandeln der aufgetragenen Schichten in eine Schicht aus intermetallischen Verbindungen (29); sowie

d) Befestigen des Chips (14) an dem Substrat (12).

5. Verfahren nach Anspruch 4, in welchem das Aufschmelzen und die Befestigungsschritte kombiniert sind.

**Revendications**

1. Connexion électrique et mécanique entre une pastille semiconductrice (14) et des conducteurs (10) sur un substrat isolant (12), ladite connexion comportant un amas de soudure (30) et un plot formant borne rattachant ledit amas de soudure à ladite pastille et/ou audit substrat, dans laquelle, avant la formation de ladite connexion, ledit plot comporte des couches successives de chrome (24), de cuivre (26) et d'or (28), ladite couche de cuivre ayant une épaisseur comprise entre 0,08 et 0,25 µm (800 à 2500 Å), de telle sorte que lorsque l'on forme ladite connexion par fusion de l'amas, les couches successives soient converties en une couche de composé intermétallique et que les efforts qui se produisent avec la formation du composé intermétallique soient réduits.

2. Connexion de la revendication 1, dans laquelle ladite couche d'or (28) a une épaisseur qui n'est pas supérieure à 0,25 µm (2500 Å).

3. Connexion de la revendication 1 ou 2, dans laquelle ledit plot est rattaché à ladite pastille (14), et comporte de plus une zone d'aluminium (18) disposée sur ladite pastille.

4. Procédé pour connecter électriquement et mécaniquement une pastille de circuit intégré (14) à des conducteurs (10) sur un substrat isolant (12), caractérisé par les étapes suivantes:

a) la déposition séquentielle de couches de chrome (24), de cuivre (26), et d'or (28), ladite couche de cuivre ayant une épaisseur comprise entre 0,08 et 0,25 µm (800 à 2500 Å) et ladite couche d'or ayant de préférence une épaisseur qui n'est pas supérieure à 0,25 µm (2500 Å);

b) la formation d'un amas de soudure plomb/étain (30) sur lesdites couches déposées (24 à 28), ledit ams ayant de préférence une épaisseur totale de 125 µm environ;

c) la fusion du dôme de soudure, convertissant lesdites couches déposées en une couche de composé intermétallique (29); et

d) le montage de ladite pastille (14) sur ledit substrat (12).

5. Procédé de la revendication 4, dans lequel les étapes de ladite fusion et dudit montage sont combinées.

0 068 091

FIG.1

FIG.2

FIG.3